# EUROPEAN PATENT APPLICATION

(11) **EP 1 777 319 A1**
(43) Date of publication of application: **25.04.2007**
(21) Application number: 05765701.7
(22) Date of filing: 13.07.2005
(51) Int. Cl.: C23C 14/24, C04B 35/04, H01J 11/02

(54) **MgO DEPOSITION MATERIAL**

(30) Priority: 14.07.2004 JP 2004206623; 21.09.2004 JP 2004272720; 28.12.2004 JP 2004379090; 15.04.2005 JP 2005117719
(71) Applicant: MITSUBISHI MATERIALS CORPORATION, Chiyoda-ku, Tokyo 100-8117 (JP)
(72) Inventor: SAKURAI, Hideaki, MITSUBISHI MATERIALS CORPORATION, Naka-shi, Ibaraki 3110102 (JP); MAYUZUMI, Yoshitaka, MITSUBISHI MATERIALS CORP., Naka-shi, Ibaraki 3110102 (JP); HIRATA, Hiroki, MITSUBISHI MATERIALS CORPORATION, Naka-shi, Ibaraki 3110102 (JP)
(74) Representative: Gille Hrabal Struck Neidlein Prop Roos
(86) International application number: PCT/JP2005/012925
(87) International publication number: WO 2006/006627

(57) **Abstract**

A MgO vapor deposition material, which is used to form a protective film of a plasma display panel, comprises pellets having MgO purity of 98% or more and relative density of 90% or more. The pellets contain one, or two or more kinds of elements selected from the group consisting of Y, La, Ce, Pr, Nd, Pm, and Sm. The concentration of Y is from 5 to 10,000 ppm in the case of containing Y, the concentration of La is from 5 to 15,000 ppm in the case of containing La, the concentration of Ce is from 5 to 16,000 ppm in the case of containing Ce, the concentration of Pr is from 5 to 16,000 ppm in the case of containing Pr, the concentration of Nd is from 5 to 16,000 ppm in the case of containing Nd, the concentration of Pm is from 5 to 16,000 ppm in the case of containing Pm, and the concentration of Sm is from 5 to 16,000 ppm in the case of containing Sm.

## Description

### TECHNICAL FIELD

The present invention relates to a MgO vapor deposition material which forms a MgO film used as a protective film of an AC type plasma display panel. More specifically, the present invention relates to a MgO film which has good responsibility over a wide temperature range, and a MgO vapor deposition material which can be used to form a plasma display panel using the same.
This application claims priority on Japanese Patent Application No. 2004-206623 filed on July 14, 2004, Japanese Patent Application No. 2004-272720 filed on September 21, 2004, Japanese Patent Application No. 2004-379090 filed on December 28, 2004 and Japanese Patent Application No. 2005-117719 filed on April 15, 2005, the disclosure of which is incorporated by reference herein.

### BACKGROUND ART

In recent years vigorous efforts have been made in the research, development and commercialization of various flat displays including liquid crystal display, and the volume of production thereof has been rapidly increasing. Development and commercialization activities have also been vigorous for the full-color plasma display panels (hereinafter abbreviated as PDP). The PDP is advantageous for the manufacture of large-sized displays, and is considered to be most promising in realizing a large-screen wall-hung TV set of high definition picture quality in a short period of time. PDP sets of 40-inch class in diagonal size have been already in commercial production. PDP is divided by the electrode structure into AC type which has metal electrodes covered by a dielectric glass material and DC type which has metal electrodes exposed in discharge space.

In the initial stage of developing the AC type PDP, there was such a problem that discharge starting voltage increased over time due to a change in the dielectric glass layer caused by sputtering of ions, since the dielectric glass layer surface was exposed to the discharge space and was therefore exposed to direct discharge. To solve this problem, it was attempted to form a protective film for the dielectric glass layer using various oxides having high heat of sublimation. The protective film makes direct contact with the discharge gas, and therefore plays important roles. Specifically, the protective film is required to have (1) low discharge voltage, (2) resistance to sputtering during discharge, (3) quick discharge responsibility, and (4) insulation property. MgO meets these requirements and is accordingly used to form the protective film. The protective film formed from MgO protects the surface of the dielectric glass layer from sputtering during discharge, and is critical for ensuring the long service life of the PDP.

However, the use of MgO in the protective film involves a problem of rash of disturbance in display called the black noise. The black noise refers to such a defect of display panel that a cell to be lit (selected cell) does not light up. It is known that the black noise tends to occur in the border between a region to be lit and a region to remain dark. This defect does not occur in such a manner as all the cells in one line or in one row do not light up, but occurs at dispersed cells. Therefore, the black noise is believed to occur due to failure of addressed discharge or, if addressed discharge does occur, error in addressing due to low intensity.

As means for solving the problems described above, such a PDP system has been disclosed that uses a protective film against sputtering constituted from MgO film which is formed by a vacuum film forming method so as to contain Si with the concentration in a range from 500 to 10,000 ppm by weight (refer to, for example, Japanese Patent No. 3,247,632). According to Japanese Patent No. 3,247,632, addressing error that causes the black noise can be suppressed from occurring, by containing Si in the MgO film with the concentration described above.
Such a PDP system has also been disclosed that uses a protective film against sputtering constituted from MgO film which is formed to contain Si with the concentration in a range from 1,000 to 40,000 ppm by weight by pyrolysis of a fatty acid salt (refer to, for example, Japanese Unexamined Patent Publication (Kokai) No. 2001-110321). According to the technology disclosed in Japanese Unexamined Patent Publication (Kokai) No. 2001-110321, a trace component in the MgO film formed by pyrolysis of the fatty acid salt improves the electrical property so that the discharge of secondary electrons increases to compensate for the decrease in the effective voltage due to residual charge. As a result, residual charge itself quickly diminishes, so as to suppress the addressing error that causes the black noise.

In the meantime, it has been reported that the responsibility of a PDP panel is affected by various conditions such as the configuration of the discharge cells, voltage applied to drive the panel and the frequency of the applied voltage (refer to, for example, A. Seguin, L. Tessier, H. Doyeux and S. Salavin, "Measurement of Addressing Speed in Plasma Display Devices.", IDW'99, p699-702). A. Seguin, L. Tessier, H. Doyeux and S. Salavin, "Measurement of Addressing Speed in Plasma Display Devices.", IDW'99, p699-702 describes a technique to evaluate the responsibility of PDP.
It has also been reported that the responsibility can be improved by irradiating the discharge cell with vacuum ultraviolet ray (refer to, for example, R. Ganter, Th. Callegari, N. Posseme, B. Caillier and J. P. Boeuf, "Photoemission in Plasma Display Panel Discharge Cells", IDW'00, p731-734). R. Ganter, Th. Callegari, N. Posseme, B. Caillier and J. P. Boeuf, "Photoemission in Plasma Display Panel Discharge Cells", IDW'00, p731-734 also describes a technique to evaluate the responsibility of PDP.

### DISCLOSURE OF THE INVENTION

Japanese Patent No. 3,247,632, Japanese Unexamined Patent Publication (Kokai) No. 2001-110321, A. Seguin, L. Tessier, H. Doyeux and S. Salavin, "Measurement of Addressing Speed in Plasma Display Devices.", IDW'99, p699-702, and R. Ganter, Th. Callegari, N. Posseme, B. Caillier and J. P. Boeuf, "Photoemission in Plasma Display Panel Discharge Cells", IDW'00, p731-734 make no mention of temperature as the condition for evaluating the responsibility. It is supposed that the responsibility is evaluated at temperatures near the room temperature in these documents.
However, the temperatures at which the PDP operation is guaranteed vary greatly by the manufacture from 0°C or even -15°C at the lowest to 70°C or even 90°C at the highest. The present inventors evaluated the discharge responsibility over a wide temperature range from -15 to 90ºC and found out that the responsibility has temperature dependency, after an intensive research. Specifically, when the discharge response time exceeds the threshold at a given temperature, a failure occurs in the writing discharge and causes flicker in the panel. In the case of a PDP panel having poor responsibility, it is necessary to make the addressing period longer, which shortens the sustainment period. As a result, the panel cannot display with sufficiently high brightness, which has been compensated for by carrying out dual scan thereby improving the brightness of the panel display. However, dual scan requires a larger number of addressing ICs which results in higher cost of building the control circuit.
An object of the present invention is to provide a MgO vapor deposition material which can be produced with good yield and has good responsibility over a wide temperature range, and also can remarkably decrease the number of addressing ICs without lowering panel brightness, and a MgO film and PDP which use the same.

A first aspect of the present invention lies in an improvement of a MgO vapor deposition material used to form a protective film of a plasma display panel (PDP). The MgO vapor deposition material according to a first aspect of the present invention is characterized by comprising pellets having MgO purity of 98% or more and relative density of 90% or more, wherein the pellets contain one, or two or more kinds of elements selected from the group consisting of Y, La, Ce, Pr, Nd, Pm, and Sm, and the concentration of Y is from 5 to 10,000 ppm in the case of containing Y, the concentration of La is from 5 to 16,000 ppm in the case of containing La, the concentration of Ce is from 5 to 16,000 ppm in the case of containing Ce, the concentration of Pr is from 5 to 16,000 ppm in the case of containing Pr, the concentration of Nd is from 5 to 16,000 ppm in the case of containing Nd, the concentration of Pm is from 5 to 16,000 ppm in the case of containing Pm, and the concentration of Sm is from 5 to 16,000 ppm in the case of containing Sm.
In the MgO vapor deposition material described in this first aspect, when an MgO film is formed using a MgO vapor deposition material in which the concentration of one, or two or more kinds of elements selected from the group consisting of Y, La, Sc, Ce, Pr, Nd, Pm, and Sm contained in MgO pellets is in the above range, the resulting MgO film has good discharge responsibility over a wide temperature range.

In the MgO vapor deposition material of the first aspect, the MgO pellets may be in the form of a polycrystal or a single crystal.
In the MgO vapor deposition material, the effects remarkably vary depending on a difference in the composition, not on a difference in the structure, for example, the MgO pellets are in the form of a polycrystal or a single crystal. Therefore, even if the MgO pellets are not only in the form of a polycrystalline but also a single crystal, when a MgO film is formed using the MgO vapor deposition material with the composition in the range described in the first aspect, the resulting MgO film has good discharge responsibility over a wide temperature range.
The MgO pellets are preferably in the form of a polycrystal obtained by a sintering method or a single crystal obtained by an electromelting method.
The concentration of Y is preferably from 10 to 5,000 ppm in the case of containing Y, the concentration of La is preferably from 10 to 7,000 ppm in the case of containing La, the concentration of Ce is preferably from 10 to 8,000 ppm in the case of containing Ce, the concentration of Pr is preferably from 10 to 7,000 ppm in the case of containing Pr, the concentration of Nd is preferably from 10 to 7,000 ppm in the case of containing Nd, the concentration of Pm is preferably from 10 to 7,000 ppm in the case of containing Pm, and the concentration of Sm is preferably from 10 to 7,000 ppm in the case of containing Sm.
The concentration of Y is more preferably from 20 to 1,000 ppm in the case of containing Y, the concentration of La is more preferably from 20 to 1,000 ppm in the case of containing La, the concentration of Ce is more preferably from 20 to 1,000 ppm in the case of containing Ce, the concentration of Pr is more preferably from 20 to 1,000 ppm in the case of containing Pr, the concentration of Nd is more preferably from 20 to 1,000 ppm in the case of containing Nd, the concentration of Pm is more preferably from 20 to 1,000 ppm in the case of containing Pm, and the concentration of Sm is more preferably from 20 to 1,000 ppm in the case of containing Sm.
The concentration of Y is still more preferably from 20 to 300 ppm in the case of containing Y, the concentration of La is still more preferably from 20 to 800 ppm in the case of containing La, the concentration of Ce is still more preferably from 20 to 800 ppm in the case of containing Ce, the concentration of Pr is still more preferably from 20 to 800 ppm in the case of containing Pr, the concentration of Nd is still more preferably from 20 to 800 ppm in the case of containing Nd, the concentration of Pm is still more preferably from 20 to 800 ppm in the case of containing Pm, and the concentration of Sm is still more preferably from 20 to 800 ppm in the case of containing Sm.

A second aspect of the present invention lies in a MgO film which is formed by a vacuum film forming method using the MgO vapor deposition material of the first aspect as a target material.
In the MgO film of this second aspect, since the MgO film was formed using the MgO vapor deposition material of the first aspect, this MgO film has good discharge responsibility over a wide temperature range.
It is preferred that the MgO film of the second aspect contains one, or two or more kinds of elements selected from the group consisting of Y, La, Ce, Pr, Nd, Pm, and Sm, wherein the concentration of Y is from 5 to 10,000 ppm in the case of containing Y, the concentration of La is from 5 to 15,000 ppm in the case of containing La, the concentration of Ce is from 5 to 16,000 ppm in the case of containing Ce, the concentration of Pr is from 5 to 16,000 ppm in the case of containing Pr, the concentration of Nd is from 5 to 16,000 ppm in the case of containing Nd, the concentration of Pm is from 5 to 16,000 ppm in the case of containing Pm, and the concentration of Sm is from 5 to 16,000 ppm in the case of containing Sm.
Furthermore, the vacuum film forming method is preferably an electron-beam evaporation method or an ion plating method.

A third aspect of the present invention lies in a MgO film comprising a base layer formed using a MgO vapor deposition material which does not contain any elements of Y, La, Ce, Pr, Nd, Pm, and Sm as a target material, and a surface layer formed on the surface of the base layer using the MgO vapor deposition material of the first aspect as a target material.
In the MgO film of this third aspect, the production cost of the MgO film can be reduced by forming a cheap base layer in a large thickness and forming an expensive surface layer in a small thickness.
The MgO film comprises a plurality of columnar crystal grains disposed to rise in a planar array on the surface of the base glass substrate, and the mean diameter of the columnar crystal grains is in a range from 20 to 100 nm, and also the angle between the longitudinal direction of the columnar crystal grain and the line normal to the surface of the base glass substrate is in a range from 0 to 50 degrees.
It is preferable that crystal of the MgO film is either oriented in (111) plane or has preferred orientation in (111) plane, or is either oriented in (100) plane or has preferred orientation in (100) plane, or is either oriented in (110) plane or has preferred orientation in (110) plane.
A fourth aspect of the present invention is PDP comprising a dielectric layer and the MgO film of the second or third aspect provided on the dielectric layer.
In PDP of this fourth aspect, a MgO film for PDP (a MgO film of the second or third aspect) was formed using the MgO vapor deposition material of the first aspect, and thus good responsibility is obtained over a wide temperature range and brightness of the panel can be improved. Since necessary and sufficient panel brightness can be ensured, the number of addressing ICs can be remarkably decreased without lowering panel brightness.

As described above, according to the present invention, since the MgO vapor deposition material comprises pellets having MgO purity of 98% or more and relative density of 90% or more and the pellets contain a predetermined amount of one, or two or more kinds of elements selected from the group consisting of Y, La, Ce, Pr, Nd, Pm, and Sm, when a MgO film is formed using this MgO vapor deposition material, the resulting MgO film has good discharge responsibility over a wide temperature range.
Also even if the MgO pellets are not only in the form of a polycrystalline but also a single crystal, when a MgO film is formed using the MgO vapor deposition material with the composition in the range described above, the resulting MgO film has good discharge responsibility over a wide temperature range.
Also if a base layer is formed using a MgO vapor deposition material which does not contain any elements of Y, La, Ce, Pr, Nd, Pm, and Sm as a target material and a surface layer is formed on the surface of the base layer using a MgO vapor deposition material containing one, or two or more kinds of elements selected from the group consisting of Y, La, Ce, Pr, Nd, Pm, and Sm as a target material, the production cost of the MgO film can be reduced by forming a cheap base layer in a large thickness and forming an expensive surface layer in a small thickness.
Furthermore, when a MgO film is formed using the MgO vapor deposition material, the resulting MgO film has good discharge responsibility over a wide temperature range. When a MgO film formed using the MgO vapor deposition material is applied to PDP, good responsibility is obtained over a wide temperature range and brightness of the panel can be improved, and also necessary and sufficient panel brightness can be ensured, and thus the number of addressing ICs can be remarkably decreased without lowering panel brightness.

### BRIEF DESCRIPTION OF THE DRAWINGS

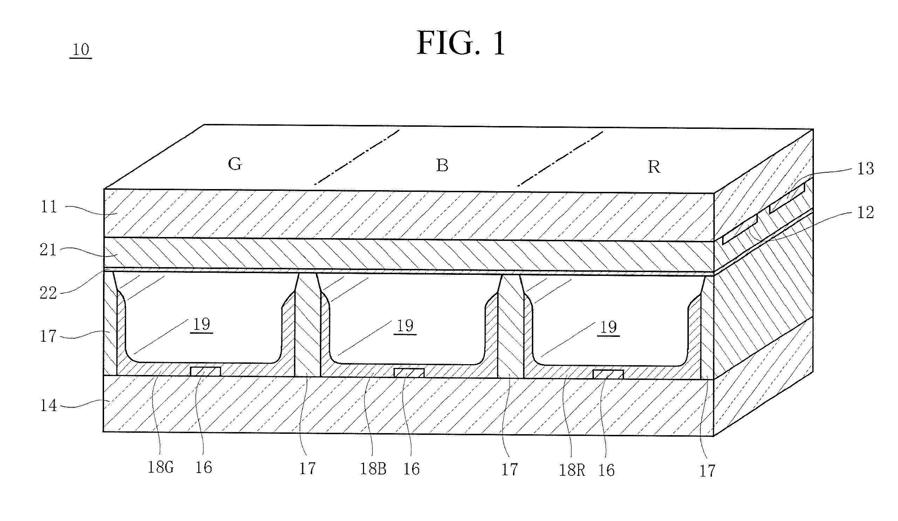

Fig. 1 is a cross-sectional perspective view at relevant part showing an internal structure of PDP according to the embodiment of the present invention.

### [Brief Description of Reference Symbols]

- 10: AC type PDP
- 22: Protective film (MgO film)

### BEST MODE FOR CARRYING OUT THE INVENTION

Best mode for carrying out the present invention will now be described with reference to the accompanying drawings.
The present inventors examined in detail an influence of impurity species and the content in a MgO vapor deposition material and a MgO film formed using the MgO vapor deposition material on discharge responsibility, and confirmed that the concentration of one, or two or more kinds of elements selected from the group consisting of Y, La, Ce, Pr, Nd, Pm, and Sm contained in MgO pellets exerts a large influence. As the concentration of one, or two or more kinds of elements selected from the group consisting of Y, La, Ce, Pr, Nd, Pm, and Sm in MgO pellets increases, discharge responsibility generally becomes better, however, when the concentration of one, or two or more kinds of elements selected from the group consisting of Y, La, Ce, Pr, Nd, Pm, and Sm further increases, discharge responsibility generally deteriorates. Therefore, optimum concentration range of one, or two or more kinds of elements selected from the group consisting of Y, La, Ce, Pr, Nd, Pm, and Sm exists taking account of application to the product. Temperature dependency exists because secondary electron emission capacity is improved by the addition of elements selected from the group consisting of Y, La, Ce, Pr, Nd, Pm, and Sm. One, or two or more kinds of elements selected from the group consisting of Y, La, Ce, Pr, Nd, Pm, and Sm include misch metal (sometimes referred to as Mm) as a mixture containing La, Ce, and Nd as a main component.

The MgO vapor deposition material, in which the concentration of one, or two or more kinds of elements selected from the group consisting of Y, La, Ce, Pr, Nd, Pm, and Sm in the present invention was adjusted, is a deposition material used to form a MgO film as a protective film of PDP, and comprises polycrystalline MgO pellets which have MgO purity of 98% or more, preferably 98.4% or more, and have relative density of 90% or more, preferably 95% or more. The MgO purity of the polycrystalline MgO pellets was limited to 98% or more by the following reason. Namely, when the MgO purity is less than 98%, the discharge response time increases and also reproducibility of data of the discharge response time is inferior. The relative density was limited to 90% or more because splashing during film formation increases when the relative density is less than 90%. Also the MgO vapor deposition material of the present invention may contain a rare earth element (for example, Sc) other than the rare earth elements, and other elements (for example, Si, Ca, Al, Fe, etc.). The MgO pellets is in the form of a polycrystal in this embodiment, but also may be in the form of a single crystal. In DESCRIPTION and CLAIMS of the present invention, the purity of the MgO vapor deposition material means the value obtained by subtracting the content of the elements other than Mg and O contained in the MgO pellets from 100% (total weight of pellets). As used herein, the element to be considered in the calculation includes H, B, C, N, Na, Al, Si, P, S, Cl, K, Ca, Ti, V, Cu, Zn, Zr, Mo, and Pb; and rare earth elements such as Sc, Y, La, Ce, Pr, Nd, Pm, and Sm.

The concentration of Y is from 5 to 10,000 ppm, preferably from 10 to 5,000 ppm, and more preferably from 20 to 1,000 ppm, in the case of containing Y, the concentration of La is from 5 to 15,000 ppm, preferably from 10 to 7,000 ppm, and more preferably from 20 to 1,000 ppm, in the case of containing La, the concentration of Ce is from 5 to 16,000 ppm, preferably from 10 to 8,000 ppm, and more preferably from 20 to 1,000 ppm, in the case of containing Ce, the concentration of Pr is from 5 to 16,000 ppm, preferably from 10 to 7,000 ppm, and more preferably from 20 to 1,000 ppm, in the case of containing Pr, the concentration of Nd is from 5 to 16,000 ppm, preferably from 10 to 7,000 ppm, and more preferably from 20 to 1,000 ppm, in the case of containing Nd, the concentration of Pm is from 5 to 16,000 ppm, preferably from 10 to 7,000 ppm, and more preferably from 20 to 1,000 ppm, in the case of containing Pm, and the concentration of Sm is from 5 to 16,000 ppm, preferably from 10 to 7,000 ppm, and more preferably from 20 to 1,000 ppm, in the case of containing Sm. The concentration of these elements is the concentration based on 100% by weight of the MgO pellets. The concentration of Y was limited in a range from 5 to 10,000 ppm in the case of containing Y by the following reason. Namely, when the concentration is less than 5 ppm, it is difficult to stably control the concentration and, when the concentration exceeds 10,000 ppm, the discharge response time increases. The concentration of La was limited in a range from 5 to 15,000 ppm in the case of containing La by the following reason. Namely, when the concentration is less than 5 ppm, it is difficult to stably control the concentration and, when the concentration exceeds 15,000 ppm, the discharge response time increases. The concentration of Sc was limited in a range from 5 to 5,000 ppm in the case of containing Sc by the following reason. Namely, when the concentration is less than 5 ppm, it is difficult to stably control the concentration and, when the concentration exceeds 5,000 ppm, the discharge response time increases. The concentration of Ce in case of containing Ce, the concentration of Pr in case of containing Pr, the concentration of Nd in case of containing Nd, and the concentration of Sm in case of containing Sm were limited in a range from 5 to 16,000 ppm, respectively, by the following reason. Namely, when the concentration is less than 5 ppm, it is difficult to stably control the concentration and, when the concentration exceeds 16,000 ppm, the discharge response time increases.

When an extremely trace amount of the above elements such as Y, La, and Ce are present in the MgO vapor deposition material, it is not present as a granular deposit at the boundary or in grains of a MgO matrix, but is uniformly dispersed in the MgO vapor deposition material. The element is present as an oxide in the MgO vapor deposition material. For example, it is considered that Y is present in the form of Y₂O₃ and La is present in the form of La₂O₃. Also, it is considered that Ce is present in the form of CeO₂ or Ce₂O₃. Also, it is considered that Pr is present in the form of Pr₆O₁₂ and Nd is present in the form of Nd₂O₃. Furthermore, it is considered that Pm is present in the form of Pm₂O₃ and Sm is present in the form of Sm₂O₃.

The method for producing a MgO vapor deposition material of the present invention with such a constitution will now be described.

### (1) In the case of producing by sintering method using Y as additional element

First, a high purity MgO powder having purity of 98% or more, a high purity yttrium oxide powder in the amount which enables the concentration of Y contained in MgO to be adjusted in a range from 5 to 10,000 ppm, a binder, and an organic solvent are mixed to prepare a slurry having a concentration of 30 to 75% by weight. Preferably, a slurry having a concentration of 40 to 65% by weight is prepared. The concentration of the slurry was limited to 30 to 75% by weight by the following reason. When the concentration is more than 75% by weight, it is difficult to perform stable mixing granulation because of the non-aqueous slurry. On the other hand, when the concentration is less than 30% by weight, a dense MgO sintered compact having a uniform structure is not obtained. The mean particle size of the MgO powder is preferably in a range from 0.1 to 5.0 µm. The mean particle size of the MgO powder was defined in the above range by the following reason. When the mean particle size is less than the lower limit, excessively fine powders are aggregated and handling of the powder becomes inferior and thus it becomes difficult to prepare a high concentration slurry. On the other hand, when the mean particle size is more than the upper limit, it is difficult to control a fine structure and dense pellets can not be obtained.

Taking account of the prevention of uneven distribution of Y, which are present in an yttrium oxide powder, reactivity with a MgO matrix, and purity of a Y compound, it is preferred to add yttrium oxide particles having a primary particle size of submicron order or less.
As the binder, polyethylene glycol and polyvinyl butyral are preferably used. As the organic solvent, ethanol and propanol are preferably used. It is preferred to add 0.2 to 5.0% by weight of the binder.

Also wet mixing of the high purity powder, the binder and the organic solvent, particularly wet mixing of the high purity powder and the organic solvent as a disperse medium is performed using a wet ball mill or a stirring mill. In the case of the wet ball mill, when balls made of ZrO₂ are used, wet mixing is performed for 8 to 24 hours, preferably 20 to 24 hours, using a lot of balls made of ZrO₂ having a diameter of 5 to 10 mm. The diameter of balls made of ZrO₂ was limited in a range from 5 to 10 mm by the following reason. When the diameter is less than 5 mm, mixing is not sufficiently performed. On the other hand, when the diameter is more than 10 mm, there is such a problem that impurities increase. The mixing time is long as at least 24 hours because less impurities are generated even if continuous mixing is performed for a long time.
In the case of the stirring mill, wet mixing is performed for 0.5 to 1 hours using balls made of ZrO₂ having a diameter of 1 to 3 mm. The diameter of balls made of ZrO₂ was limited in a range from 1 to 3 mm by the following reason. When the diameter is less than 1 mm, mixing is not sufficiently performed. On the other hand, when the diameter is more than 3 mm, there is such a problem that impurities increase. The mixing time is short as at most one hour by the following reason. When the mixing time is more than one hour, balls are abraded during mixing of raw materials, thereby causing generation of impurities, and also the mixing is sufficiently performed for only one hour.

Then, the slurry is spray-dried to obtain a mixed granuled powder having a mean particle size of 50 to 250 µm, preferably 50 to 200 µm. This granuled powder is charged in a predetermined mold and then compressed under a predetermined pressure. The spray drying is preferably performed using a spray dryer, and a uniaxial pressing apparatus or a cold isostatic press (CIP), each being equipped with the predetermined mold, are used. In the case of the uniaxial pressing apparatus, the granuled powder is uniaxially pressed under a pressure of 750 to 2,000 kg/cm², preferably 1,000 to 1,500 kg/cm². In the case of the CIP molding apparatus, the granuled powder is CIP-pressed under a pressure of 1,000 to 3,000 kg/cm², preferably 1,500 to 2,000 kg/cm². The pressure was limited in the above range so as to increase the density of the green compact and to prevent deformation after sintering, thereby eliminating after working.

Furthermore, the green compact is sintered at a predetermined temperature. The sintering is performed in an atmospheric air, inert gas, vacuum or reducing gas atmosphere at a temperature of 1,350°C or higher, preferably 1,400 to 1,800°C for 1 to 10 hours, preferably 2 to 8 hours. Thus, pellets having relative density of 90% or more are obtained. The sintering is performed under an atmospheric pressure. When pressure sintering is performed, like hot press (HP) sintering or hot isostatic pressing (HIP) sintering, the sintering is preferably performed in an inert gas, vacuum or reducing gas atmosphere at a temperature of 1,350°C or higher for 1 to 5 hours. Thus, a MgO film is formed on the surface of a substrate by a vacuum film forming method using the polycrystalline MgO vapor deposition material in the form of pellets thus obtained as a target material.

### (2) In case of producing by electromelting method using Y as additional element

A MgO raw material having comparatively low quality (for example, Mg(OH)₂ powder), and a yttrium oxide powder in the amount which enables the concentration of Y contained in MgO to be adjusted in a range from 5 to 10,000 ppm are mixed, and then the mixture is charged in a bath. The mixture in the bath was melted at high temperature utilizing arc discharge and then annealed to obtain an ingot of a single crystalline of an oxide having high quality. Furthermore, the single crystalline ingot was crushed to obtain pellets of a single crystalline MgO vapor deposition material. Thus, a MgO film is formed on the surface of a substrate by a vacuum film forming method using the polycrystalline MgO vapor deposition material in the form of pellets thus obtained as a target material.
When La, Ce, Pr, Nd, Pm, or Sm is used as an additional element, a MgO vapor deposition material is produced in the same manner as described above using La, Ce, Pr, Nd, Pm, or Sm in place of Y.

Examples of the vacuum film forming method used to form the MgO film include electron-beam evaporation method and ion plating method. The MgO film contains one, or two or more kinds of elements selected from the group consisting of Y, La, Ce, Pr, Nd, Pm, and Sm. The concentration of Y is from 5 to 10,000 ppm, preferably from 10 to 5,000 ppm, and more preferably from 20 to 1,000 ppm, in case of containing Y. The concentration of La is from 5 to 15,000 ppm, preferably from 10 to 7,000 ppm, and more preferably from 20 to 1,000 ppm, in case of containing La. The concentration of Ce is from 5 to 16,000 ppm, preferably from 10 to 8,000 ppm, and more preferably from 20 to 1,000 ppm, in case of containing Ce. The concentration of Pr is from 5 to 16,000 ppm, preferably from 10 to 7,000 ppm, and more preferably from 20 to 1,000 ppm, in case of containing Pr. The concentration of Nd is from 5 to 16,000 ppm, preferably from 10 to 7,000 ppm, and more preferably from 20 to 1,000 ppm, in case of containing Nd. The concentration of Pm is from 5 to 16,000 ppm, preferably from 10 to 7,000 ppm, and more preferably from 20 to 1,000 ppm, in case of containing Pm. The concentration of Sm is from 5 to 16,000 ppm, preferably from 10 to 7,000 ppm, and more preferably from 20 to 1,000 ppm, in case of containing Sm. The concentration of these elements is the concentration based on 100% by weight of the MgO film. The reason why the concentration of the element such as Y contained in the MgO film was limited in the above range is the same as that of the limitation of the concentration of the element such as Y contained in the MgO vapor deposition material.

The MgO film can comprise a base layer formed by a MgO vapor deposition material which does not contain any elements of Y, La, Ce, Pr, Nd, Pm, and Sm as a target material, and a surface layer containing one, or two or more kinds of elements selected from the group consisting of Y, La, Ce, Pr, Nd, Pm, and Sm. In this case, the production cost of the MgO film can be reduced by forming a cheap base layer in a large thickness and forming an expensive surface layer in a small thickness. The MgO film may comprise a plurality of columnar crystal grains disposed to rise in a planar array on the surface of the base glass substrate, and also the mean diameter of the columnar crystal grains may be in a range from 20 to 100 nm and the angle between the longitudinal direction of the columnar crystal grain and the line normal to the surface of the base glass substrate may be in a range from 0 to 50 degrees. The reason why the mean diameter of the columnar crystal grains was limited in a range from 20 to 100 nm by the following reason. When the mean diameter is less than 20 nm, crystallinity becomes insufficient. On the other hand, when the mean diameter is more than 100 nm, the amount of a gas absorbed in the MgO film increases and it becomes difficult to perform the evacuation step of PDP. The angle between the longitudinal direction of the columnar crystal grain and the line normal to the surface of the base glass substrate was limited in a range from 0 to 50 degrees by the following reason. The MgO film is deposited on a substrate while conveying the substrate at a predetermined rate. Namely, when a conveyance rate of the substrate varies, the above angle varies in a range from 0 to 50 degrees. Furthermore, it is preferable that crystal of the MgO film is either oriented in (111) plane or has preferred orientation in (111) plane, or is either oriented in (100) plane or has preferred orientation in (100) plane, or is either oriented in (110) plane or has preferred orientation in (110) plane. When the crystal of the MgO film is either oriented in the above planes or has preferred orientation in above planes, discharge characteristics and resistance to sputtering are improved. In the MgO film containing two or more kinds of elements selected from the group consisting of Y, La, Ce, Pr, Nd, Pm, and Sm, unevenness of the element concentration in the film direction, for example, inclination of the element concentration in the film direction may be present.

An internal structure of a PDP 10 of the present invention is shown in Fig. 1.
In a AC type PDP 10 of a surface discharge type, a pair of a sustain electrode 12 and a scan electrode 13 are usually disposed in the lateral direction of the screen of a front glass substrate 11, and an address electrode 16 is disposed in the longitudinal direction of the screen of a rear glass substrate 14. The gap between the sustain electrode 12 and the scan electrode 13 is referred to as a discharge gap and this gap is set to about 80 µm. The front glass substrate 11 and the rear glass substrate 14 are partitioned off through a barrier plate 17 having a height of about 100 to 150 µm and a phosphor powder 18 is coated on the wall surface and the bottom of the barrier plate 17. In the case of color display, phosphors 18G, 18B, 18R of three colors (R, G, B) are respectively coated on the wall surface and the bottom of the barrier plate 17 which forms three discharge spaces are dispopsed in the line direction to form three subpixels (unit light emission region), which serve as one pixel. In the discharge space 19 formed by the front glass substrate 11, the rear glass substrate 14 and the barrier plate 17, a fill gas is filled. As the fill gas, a mixed gas of an inert gas such as Ne (neon) or Xe (xenon) is used.
On the surface of a dielectric glass layer 21 on which the sustain electrode 12 and the scan electrode 13 are coated, a protective film (MgO film) 22 having high resistance to sputtering is provided so as to decrease ion bombardment caused by a discharge gas during discharge. Since the material and quality of the film exert a large influence on discharge characteristics of the protective film 22 in PDP, this protective film serves as a discharge electrode. As the protective film material, a MgO film of the present invention as an insulator, which is excellent in resistance to sputtering, and also has a high secondary electron emission coefficient, is used.

In the AC type PDP 10 of a matrix display type thus constituted, plasma discharge is produced between the sustain electrode 12 and the scan electrode 13, which face with each other, and the address electrode 16 in the discharge space 19 provided between the front glass substrate 11 and the rear glass substrate 14, and displaying is performed by irradiating the phosphor 18 provided in the discharge space 19 with ultraviolet ray generated from the gas filled in the discharge space 19. The memory effect is utilized so as to sustain the state to be lit of cells as a display device. In the case of displaying, first, wall electric charge of the entire screen is erased (reset) by the time addressing (writing) of the following image from the completion of substainment of a certain image. Then, line sequential addressing (writing) of accumulating wall electric charge only in cells to be lit (light emission). Then, a voltage (sustain voltage), which is lower than a discharge initiation voltage of alternating polarity is applied to entire cells all at once. Since a wall voltage overlaps with a sustain voltage in cells in which a wall electric charge is present, an effective voltage applied to cells exceeds the discharge initiation voltage, and thus discharge occurs. By increasing an applied frequency of the sustain voltage, apparently continuous state to be lit can be obtained.

In the addressing (writing), wall electric charge is accumulated by performing writing discharge between the address electrode of the rear glass substrate and the scan electrode of the front glass substrate. For example, when writing discharge is performed within 3 µs in conventionally used PDP in which resolution is 256 half-toning (8 subfields) in VGA (Visual Graphics Array) class, it is necessary to sequentially writing 480 lines, and therefore about 10% of the driving time is consumed for erasing wall electric charge and about 70% of the driving time is consumed for writing of image data, and thus only 20% of the driving time is remained for actually displaying images. In the case of PDP, brightness of the panel is recognized as it is as the image display time becomes longer. To improve panel brightness, the number of addressing ICs for driving the address electrode is doubled and the upper and lower portions of images are separately written (dual scan), thereby making it possible to decrease the writing time and to extend the image display time. However, the use of this method leads to higher cost of building the control circuit.

On the other hand, in the case of a MgO film 22 obtained using the MgO vapor deposition material of the present invention, since good discharge responsibility is obtained over a wide temperature range, the time required for writing discharge can be decreased. Therefore, the PDP 10 using this protective film 22 of the present invention can extend the image display time and therefore panel brightness can be improved. On the other hand, the number of addressing ICs can be remarkably decreased without lowering panel brightness.

### EXAMPLES

Examples of the present invention will now be described in more detail, along with Comparative Examples.

### <Example 1>

As a MgO vapor deposition material, polycrystalline MgO pellets having MgO purity of 99.95%, relative density of 98% and the Y content in MgO of 300 ppm was prepared. The diameter and the thickness of this MgO vapor deposition material were 5 mm and 1.6 mm, respectively. An ITO electrode and a silver electrode were laminated on the surface of a glass substrate to form electrodes and a dielectric glass layer was formed so as to coat the electrodes.
A MgO film having a thickness of 8,000 Å (800 nm) wherein crystal is oriented in (111) plane was formed on the dielectric glass layer formed on the glass substrate by an electron-beam evaporation method using the MgO vapor deposition material. Regarding film formation conditions, the ultimate vacuum degree was 1.0 × 10⁻⁴ Pa, the oxygen gas partial pressure was 1.0 × 10⁻² Pa, the substrate temperature was 200°C, and the film formation rate was 20 Å/seconds (2 nm/seconds).

### <Example 2>

In the same manner as in Example 1, except that the concentration of Y in single crystalline MgO pellets obtained by an electromelting method (plate-shaped pellets measuring 5 mm in length, 5 mm in width, and 2 mm in thickness) is 600 ppm, a MgO film was formed.

### <Example 3>

In the same manner as in Example 1, except for using a MgO vapor deposition material in which the concentration of Y contained in MgO pellets is 7,000 ppm, a MgO film was formed.

### <Example 4>

In the same manner as in Example 1, except for using a MgO vapor deposition material in which the element contained in MgO pellets is not Y but La and the concentration of La is 500 ppm, a MgO film was formed.

### <Example 5>

In the same manner as in Example 4, except for using a MgO vapor deposition material in which the concentration of La contained in MgO pellets is 5,000 ppm, a MgO film was formed.

### <Example 6>

In the same manner as in Example 4, except for using a MgO vapor deposition material in which the concentration of La contained in MgO pellets is 12,000 ppm, a MgO film was formed.

### <Example 7>

In the same manner as in Example 1, except for using a MgO vapor deposition material in which the element contained in MgO pellets is not Y but Ce and the concentration of Ce is 600 ppm, a MgO film was formed.

### <Example 8>

In the same manner as in Example 7, except for using a MgO vapor deposition material in which the concentration of Ce contained in MgO pellets is 7,000 ppm, a MgO film was formed.

### <Example 9>

In the same manner as in Example 7, except for using a MgO vapor deposition material in which the concentration of Ce contained in MgO pellets is 15,000 ppm, a MgO film was formed.

### <Example 10>

In the same manner as in Example 1, except for using a MgO vapor deposition material in which the element contained in MgO pellets is not Y but Pr and the concentration of Pr is 500 ppm, a MgO film was formed.

### <Example 11>

In the same manner as in Example 10, except for using a MgO vapor deposition material in which the concentration of Pr contained in MgO pellets is 5,000 ppm, a MgO film was formed.

### <Example 12>

In the same manner as in Example 1, except for using a MgO vapor deposition material in which the element contained in MgO pellets is not Y but Nd and the concentration of Nd is 500 ppm, a MgO film was formed.

### <Example 13>

In the same manner as in Example 12, except for using a MgO vapor deposition material in which the concentration of Nd contained in MgO pellets is 5,000 ppm, a MgO film was formed.

### <Example 14>

In the same manner as in Example 1, except for using a MgO vapor deposition material in which the element contained in MgO pellets is not Y but Pm and the concentration of Pm is 500 ppm, a MgO film was formed.

### <Example 15>

In the same manner as in Example 14, except for using a MgO vapor deposition material in which the concentration of Pm contained in MgO pellets is 5,000 ppm, a MgO film was formed.

### <Example 16>

In the same manner as in Example 1, except for using a MgO vapor deposition material in which the element contained in MgO pellets is not Y but Sm and the concentration of Sm is 500 ppm, a MgO film was formed.

### <Example 17>

In the same manner as in Example 16, except for using a MgO vapor deposition material in which the concentration of Sm contained in MgO pellets is 5,000 ppm, a MgO film was formed.

### <Example 18>

In the same manner as in Example 1, except for using a MgO vapor deposition material in which the element contained in MgO pellets is not Y but Y and La and the concentrations of Y and La are respectively 200 ppm and 500 ppm, a MgO film was formed.

### <Example 19>

In the same manner as in Example 1, except for using a MgO vapor deposition material in which the element contained in MgO pellets is not Y but Ce and Sc and the concentrations of Ce and Sc are respectively 500 ppm and 500 ppm, a MgO film was formed.

### <Example 20>

In the same manner as in Example 1, except for using a MgO vapor deposition material in which the element contained in MgO pellets is not Y but La and Sc and the concentrations of La and Sc are respectively 500 ppm and 1,000 ppm, a MgO film was formed.

### <Example 21>

In the same manner as in Example 1, except for using a MgO vapor deposition material in which the element contained in MgO pellets is not Y but La and Si and the concentrations of La and Si are respectively 1,000 ppm and 50 ppm, a MgO film was formed.

### <Example 22>

In the same manner as in Example 1, except for using a MgO vapor deposition material in which the element contained in MgO pellets is not Y but La, Ce and Fe and the concentrations of La, Ce and Fe are respectively 500 ppm, 200 ppm and 200 ppm, a MgO film was formed.

### <Comparative Example 1>

In the same manner as in Example 1, except for using a MgO vapor deposition material in which the element contained in MgO pellets is not Y but Si and the concentration of Si is 5 ppm, a MgO film was formed.

### <Comparative Example 2>

In the same manner as in Example 1, except for using a MgO vapor deposition material in which the element contained in MgO pellets is Y and the concentration of Y is 15,000 ppm, a MgO film was formed.

### <Comparative Example 3>

In the same manner as in Example 1, except for using a MgO vapor deposition material in which the element contained in MgO pellets is not Y but La and the concentration of La is 20,000 ppm, a MgO film was formed.

### <Comparative Example 4>

In the same manner as in Example 1, except for using a MgO vapor deposition material in which the element contained in MgO pellets is not Y but Ce and the concentration of Ce is 20,000 ppm, a MgO film was formed.

### <Comparative Example 5>

In the same manner as in Example 1, except for using a MgO vapor deposition material in which the element contained in MgO pellets is not Y but Pr and the concentration of Pr is 20,000 ppm, a MgO film was formed.

### <Comparative Example 6>

In the same manner as in Example 1, except for using a MgO vapor deposition material in which the element contained in MgO pellets is not Y but Nd and the concentration of Nd is 20,000 ppm, a MgO film was formed.

### <Comparative Example 7>

In the same manner as in Example 1, except for using a MgO vapor deposition material in which the element contained in MgO pellets is not Y but Pm and the concentration of Pm is 20,000 ppm, a MgO film was formed.

### <Comparative Example 8>

In the same manner as in Example 1, except for using a MgO vapor deposition material in which the element contained in MgO pellets is not Y but Sm and the concentration of Sm is 20,000 ppm, a MgO film was formed.

### <Comparative Test and Evaluation>

Using glass substrates having the MgO film obtained in Examples 1 to 22 and Comparative Examples 1 to 8, test substrates were produced. Specifically, first, a discharge gap of 80 µm was formed using an indium tin oxide (ITO) electrode and a MgO film was formed on a dielectric, and then the glass substrate was used as a front glass substrate. Then, a rear glass substrate with a barrier plate (rib) having a height of 150 µm and a pitch of 360 µm formed thereon was prepared. The rear glass substrate and the front glass substrate were disposed so as to face with each other. An Ne-4% Xe mixed gas as a discharge gas was injected into the discharge space formed by the front glass substrate, the rear glass substrate and the barrier plate.
Using the test substrate thus obtained, a pseudo address discharge test under temperature conditions of -20°C, 30°C and 90°C, namely, a counter discharge test between two glass substrates was performed. Test conditions are as follows: discharge gas pressure of 500 Torr, applied voltage of 200 V and frequency of 1 kHz. The test was performed under these conditions and near infrared ray emitted by discharge was detected by a photoelectric multiplier, and then the time required from the application of the voltage to the completion of light emission was evaluated as the response time. This response time include unevenness of statistic light emission. The test results are shown in Table 1 and Table 2, respectively.

**Table 1**

| | Additional element | Amount (ppm) | Discharge response time (µseconds) | | |
|---|---|---|---|---|---|
| | | | -20°C | 30°C | 90°C |
| Example 1 | Y | 300 | 2.10 | 0.54 | 0.55 |
| Example 2 | Y | 600 | 1.20 | 0.45 | 0.40 |
| Example 3 | Y | 7,000 | 2.20 | 1.80 | 1.80 |
| Example 4 | La | 500 | 0.43 | 0.42 | 0.42 |
| Example 5 | La | 5,000 | 0.30 | 0.25 | 0.22 |
| Example 6 | La | 12,000 | 0.88 | 0.65 | 0.70 |
| Example 7 | Ce | 600 | 0.22 | 0.21 | 0.20 |
| Example 8 | Ce | 7,000 | 0.76 | 0.54 | 0.77 |
| Example 9 | Ce | 15,000 | 1.67 | 1.55 | 1.32 |
| Example 10 | Pr | 500 | 1.35 | 1.12 | 0.67 |
| Example 11 | Pr | 5,000 | 2.65 | 1.96 | 1.65 |
| Example 12 | Nd | 500 | 1.56 | 0.99 | 0.45 |
| Example 13 | Nd | 5,000 | 1.36 | 0.64 | 0.34 |
| Example 14 | Pm | 500 | 0.83 | 0.64 | 0.44 |
| Example 15 | Pm | 5,000 | 0.99 | 0.43 | 0.25 |
| Example 16 | Sm | 500 | 0.56 | 0.45 | 0.43 |
| Example 17 | Sm | 5,000 | 1.34 | 1.01 | 0.88 |
| Example 18 | Y/La | 200/500 | 3.56 | 2.21 | 2.10 |
| Example 19 | Ce/Sc | 500/500 | 1.89 | 1.34 | 1.40 |
| Example 20 | La/Sc | 50/1,000 | 2.54 | 1.88 | 1.64 |
| Example 21 | La/Si | 1,000/50 | 3.00 | 2.15 | 2.11 |
| Example 22 | La/Ca/Fe | 500/200/200 | 2.90 | 1.51 | 0.99 |

**Table 2**

| | Additional element | Amount (ppm) | Discharge response time (µseconds) | | |
|---|---|---|---|---|---|
| | | | -20° C | 30° C | 90° C |
| Comparative Example 1 | Si | 5 | 26.66 | 10.44 | 1.97 |
| Comparative Example 2 | Y | 15,000 | 9.32 | 8.65 | 5.60 |
| Comparative Example 3 | La | 20,000 | 8.20 | 4.10 | 4.01 |
| Comparative Example 4 | Ce | 20,000 | 7.60 | 4.70 | 6.70 |
| Comparative Example 5 | Pr | 20,000 | 10.03 | 5.25 | 4.43 |
| Comparative Example 6 | Nd | 20,000 | 8.19 | 7.35 | 6.34 |
| Comparative Example 7 | Pm | 20,000 | 12.12 | 9.65 | 5.38 |
| Comparative Example 8 | Sm | 20,000 | 11.37 | 10.11 | 6.49 |

As is apparent from Table 1 and Table 2, in Comparative Example 2 in which the concentration of Y is more than the concentration range defined in the present invention, Comparative Example 3 in which the concentration of La is more than the concentration range defined in the present invention, Comparative Example 4 in which the concentration of Ce is more than the concentration range defined in the present invention, Comparative Example 5 in which the concentration of Pr is more than the concentration range defined in the present invention, Comparative Example 6 in which the concentration of Nd is more than the concentration range defined in the present invention, Comparative Example 7 in which the concentration of Pm is more than the concentration range defined in the present invention, and Comparative Example 8 in which the concentration of Sm is more than the concentration range defined in the present invention, the discharge response time increased in all temperature ranges. On the other hand, in Examples 1 to 17 in which the concentration of Y, La, Ce, Pr, Nd, Pm, or Sm is in the concentration range defined in the present invention, the discharge response time decreased over a wide temperature range. In Example 18 in which a predetermined about of Y and La were added in the concentration range defined in the present invention, Example 19 in which a predetermined about of Ce and Sc were added in the concentration range defined in the present invention, Example 20 in which a predetermined about of La and Sc were added in the concentration range defined in the present invention, Example 21 in which a predetermined about of La and Si were added in the concentration range defined in the present invention, and Example 22 in which a predetermined about of La, Ca and Fe were added in the concentration range defined in the present invention, the discharge response time decreased over a wide temperature range. The discharge response time in low temperature range of Comparative Example 1 remarkably increased. In Comparative Examples 3 and 4, emission intensity due to discharge was unstable.

## Claims

1. A MgO vapor deposition material used to form a protective film of a plasma display panel, comprising:
pellets having MgO purity of 98% or more and relative density of 90% or more,
wherein the pellets contain one, or two or more kinds of elements selected from the group consisting of Y, La, Ce, Pr, Nd, Pm, and Sm, and
the concentration of Y is from 5 to 10,000 ppm in the case of containing Y, the concentration of La is from 5 to 15,000 ppm in the case of containing La, the concentration of Ce is from 5 to 16,000 ppm in the case of containing Ce, the concentration of Pr is from 5 to 16,000 ppm in the case of containing Pr, the concentration of Nd is from 5 to 16,000 ppm in the case of containing Nd, the concentration of Pm is from 5 to 16,000 ppm in the case of containing Pm, and the concentration of Sm is from 5 to 16,000 ppm in the case of containing Sm.

2. The MgO vapor deposition material according to claim 1, wherein the MgO pellets are in the form of a polycrystal or a single crystal.

3. The MgO vapor deposition material according to claim 1, wherein the MgO pellets are in the form of a polycrystal obtained by a sintering method or a single crystal obtained by an electromelting method.

4. The MgO vapor deposition material according to claim 1, wherein the concentration of Y is from 10 to 5,000 ppm in the case of containing Y, the concentration of La is from 10 to 7,000 ppm in the case of containing La, the concentration of Ce is from 10 to 8,000 ppm in the case of containing Ce, the concentration of Pr is from 10 to 7,000 ppm in the case of containing Pr, the concentration of Nd is from 10 to 7,000 ppm in the case of containing Nd, the concentration of Pm is from 10 to 7,000 ppm in the case of containing Pm, and the concentration of Sm is from 10 to 7,000 ppm in the case of containing Sm.

5. The MgO vapor deposition material according to claim 1, wherein the concentration of Y is from 20 to 1,000 ppm in the case of containing Y, the concentration of La is from 20 to 1,000 ppm in the case of containing La, the concentration of Ce is from 20 to 1,000 ppm in the case of containing Ce, the concentration of Pr is from 20 to 1,000 ppm in the case of containing Pr, the concentration of Nd is from 20 to 1,000 ppm in the case of containing Nd, the concentration of Pm is from 20 to 1,000 ppm in the case of containing Pm, and the concentration of Sm is from 20 to 1,000 ppm in the case of containing Sm.

6. A MgO film which is formed by a vacuum film forming method using the MgO vapor deposition material described in claim 1 as a target material.

7. The MgO film according to claim 6, which contains:
one, or two or more kinds of elements selected from the group consisting of Y, La, Ce, Pr, Nd, Pm, and Sm,
wherein the concentration of Y is from 5 to 10,000 ppm in the case of containing Y, the concentration of La is from 5 to 15,000 ppm in the case of containing La, the concentration of Ce is from 5 to 16,000 ppm in the case of containing Ce, the concentration of Pr is from 5 to 16,000 ppm in the case of containing Pr, the concentration of Nd is from 5 to 16,000 ppm in the case of containing Nd, the concentration of Pm is from 5 to 16,000 ppm in the case of containing Pm, and the concentration of Sm is from 5 to 16,000 ppm in the case of containing Sm.

8. The MgO film according to claim 6, wherein the vacuum film forming method is an electron-beam evaporation method or an ion plating method.

9. A MgO film comprising a base layer formed using a MgO vapor deposition material which does not contain any elements of Y, La, Ce, Pr, Nd, Pm, and Sm as a target material, and a surface layer formed on the surface of the base layer using the MgO vapor deposition material described in claim 1 as a target material.

10. The MgO film according to claim 6, comprising a plurality of columnar crystal grains disposed to rise in a planar array on the surface of the base glass substrate, wherein the mean diameter of the columnar crystal grains is in a range from 20 to 100 nm, and the angle between the longitudinal direction of the columnar crystal grain and the line normal to the surface of the base glass substrate is in a range from 0 to 50 degrees.

11. The MgO film according to claim 9, comprising a plurality of columnar crystal grains disposed to rise in a planar array on the surface of the base glass substrate, wherein the mean diameter of the columnar crystal grains is in a range from 20 to 100 nm, and the angle between the longitudinal direction of the columnar crystal grain and the line normal to the surface of the base glass substrate is in a range from 0 to 50 degrees.

12. The MgO film according to claim 6, wherein the crystal is either oriented in (111) plane or has preferred orientation in (111) plane.

13. The MgO film according to claim 9, wherein the crystal is either oriented in (111) plane or has preferred orientation in (111) plane.

14. The MgO film as described in claim 6, wherein the crystal is either oriented in (100) plane or has preferred orientation in (100) plane.

15. The MgO film according to claim 9, wherein the crystal is either oriented in (100) plane or has preferred orientation in (100) plane.

16. The MgO film according to claim 6, wherein the crystal is either oriented in (110) plane or has preferred orientation in (110) plane.

17. The MgO film according to claim 9, wherein the crystal is either oriented in (110) plane or has preferred orientation in (110) plane.

18. A plasma display panel comprising a dielectric layer and the MgO film described in any one of claims 6 to 17 provided on the dielectric layer.
